# EUROPEAN PATENT APPLICATION

(11) **EP 2 330 877 A1**
(43) Date of publication of application: **08.06.2011**
(21) Application number: 10193174.9
(22) Date of filing: 30.11.2010
(51) Int. Cl.: H05K 3/46

(54) **Multilayered circuit board, method for manufacturing the same, and electronic apparatus**

(30) Priority: 07.12.2009 JP 2009277892
(71) Applicant: FUJITSU LIMITED, Kawasaki-shi, Kanagawa 211-8588 (JP)
(72) Inventor: Taketomi, Nobuo, Japan Kanagawa 211-8588 (JP); Kikuchi, Shunichi, Japan Kanagawa 211-8588 (JP); Nakamura, Naoki, Japan Kanagawa 211-8588 (JP); Hatanaka, Kiyoyuki, Japan Kanagawa 211-8588 (JP); Sugino, Shigeru, Japan Kanagawa 211-8588 (JP); Kanai, Ryo, Japan Kanagawa 211-8588 (JP)
(74) Representative: Holz, Ulrike

(57) **Abstract**

A method for manufacturing a multilayered circuit board, and a printed circuit board manufactured according to the method, includes laterally-aligning a first inner substrate in which first insulation layers and first conductor layers are alternately laminated and a second inner substrate in which second insulation layers and second conductor layers are alternately laminated. The second inner substrate has a lager number of layers than the first inner substrate. The laterally-aligned first inner substrate and second inner substrate are placed between a pair of third insulation layers in a thickness direction. The pair of the third insulation layer are heated under pressure in the thickness direction. A conductor pattern is formed on surfaces of the pair of the third insulation layers.

## Description

### CROSS-REFERENCE TO RELATED APPLICATION:

This application is based upon and claims the benefit of priority of the prior Japanese Patent Application No. 2009-277892, filed on December 7, 2009, the entire contents of which are incorporated herein by reference.

### FIELD:

Embodiments discussed herein are related to a multilayered circuit board, a method for manufacturing the same, and an electronic apparatus installing the multilayered circuit board therein.

### BACKGROUND:

Printed circuit boards are built or installed in many electronic apparatuses. Electronic components are mounted on the printed circuit board. The functions of the mounted electronic components determine the functions of the printed circuit board.

In recent years, electronic components have been integrated more closely into a printed circuit board with improvements in functions of the respective electronic components, leading to an increased number of leads or pins of each electronic component, and also leading to a reduction in size thereof. For example, an electronic component having a narrow pitch between pins has been proposed in the art.

In order to mount such an electronic component having a narrow pitch on a printed circuit board, a multilayered and/or fine circuit board has been desired in the art. The term "fine" used herein refers to the production of a high-fineness circuit pattern on a printed circuit board.

Eventually, specifications such as the number of layers and/or the degree of fineness of a printed circuit board may depend on the pitch between pins of an electronic component to be mounted on the printed circuit board.

However, if the entire region of a printed circuit board has a multilayered and/or fine structure, the printed circuit board results in having excessive specifications even though only a portion of a plurality of electronic components mounted on the printed circuit board has a narrow pitch between its pins. Regarding this, a cost reduction by avoiding such excessive specifications has been proposed (for example, JP-A-2004-228165, JP-A-10-284632, or JP-A-6-334353).

In JP-A-2004-228165, however, a laminated material is pasted on the part of a printed circuit board and stepped portions corresponding to differences in number of laminated layers are formed on the surface of the printed circuit board. If such stepped portions are formed, there is a need of individual soldering on each stepped portion, causing a cost increase due to an increase in number of process steps.

In JP-A-10-284632, a thin-film multilayer substrate is placed in the depressed portion of a circuit board to realize a partially multilayered circuit board where narrow pitch electronic components are mounted on the thin-film multilayer substrate. However, the electronic components are directly mounted on the thin-film multilayer substrate in the depressed portion. Thus, the multilayer circuit board and its surrounding substrate have no means for compensating a difference in thickness, so that undesirable stepped portions may exist. Therefore, in JP-A-10-284632, soldering is performed separately on the multilayered circuit board and its surrounding substrate, causing an increase in cost due to an increased number of steps of a mounting process.

In JP-A-6-334353, a dummy plate made of an insulating material is laminated on the area of a printed circuit board, where a multilayered structure is not required. The dummy plate has a thickness corresponding to the number of undesired layers on such an area. In this case, however, the laminated layers are combined together, so that the insulating materials of the respective layers may be mixed. As a result, a decrease in design flexibility can be occurred.

### SUMMARY:

According to an embodiment of the invention, a method for manufacturing a multilayered circuit board can include includes laterally-aligning a first inner substrate in which first insulation layers and first conductor layers are alternately laminated and a second inner substrate in which second insulation layers and second conductor layers are alternately laminated. The second inner substrate has a lager number of layers than the first inner substrate. The laterally-aligned first inner substrate and second inner substrate are placed between a pair of third insulation layers in a thickness direction. The pair of the third insulation layer are heated under pressure in the thickness direction. A conductor pattern is formed on surfaces of the pair of the third insulation layers.

It is to be understood that both the foregoing general description and the following detailed description are exemplary and explanatory, and are not restrictive of the invention.

### BRIEF DESCRIPTION OF DRAWINGS:

FIG. 1 is an exploded perspective view schematically illustrating a multilayered circuit board as an example of a first embodiment;

FIG. 2 is an exploded perspective view schematically illustrating the multilayered circuit board as an example of the first embodiment;

FIGs. 3A to 3C are plan views illustrating examples of arrangement of an inner substrate in the first embodiment;

FIG. 4 is an exploded perspective view schematically illustrating a printed circuit board as an example of a second embodiment;

FIG. 5 is a cross-sectional view of the printed circuit board as an example of the second embodiment;

FIGs. 6A and 6B are plan views illustrating examples of arrangement of an inner substrate in the second embodiment;

FIG. 7 is a view illustrating a first step of a process for manufacturing the inner substrate;

FIG. 8 is a view illustrating a second step of the process for manufacturing the inner substrate;

FIG. 9 is a schematic view illustrating a process for arranging the inner substrate;

FIG. 10 is a view illustrating an example of a procedure for executing the process for arranging the inner substrate;

FIG. 11 is a schematic view illustrating a heating process under pressure;

FIG. 12 is a view illustrating another example of a heating process under pressure;

FIG. 13 is a view illustrating a first step in forming a pattern or the like;

FIG. 14 is a view illustrating a second step in forming a pattern or the like;

FIG. 15 is a view illustrating a third step in forming a pattern or the like;

FIG. 16 is a view illustrating a fourth step in forming a pattern or the like;

FIG. 17 is a view illustrating an example of a layered structure applicable to each embodiment;

FIG. 18 is a view illustrating an example of a wiring structure applicable to each embodiment; and

FIG. 19 is a view illustrating a personal computer as an example of an electronic apparatus corresponding to the example of the first embodiment.

### DESCRIPTION OF EMBODIMENTS:

Hereinafter, a multilayered circuit board, a method for manufacturing such a multilayered circuit board, and an electronic apparatus installing the multilayered circuit board according to the embodiments of the present invention will be described with reference to the attached drawings.

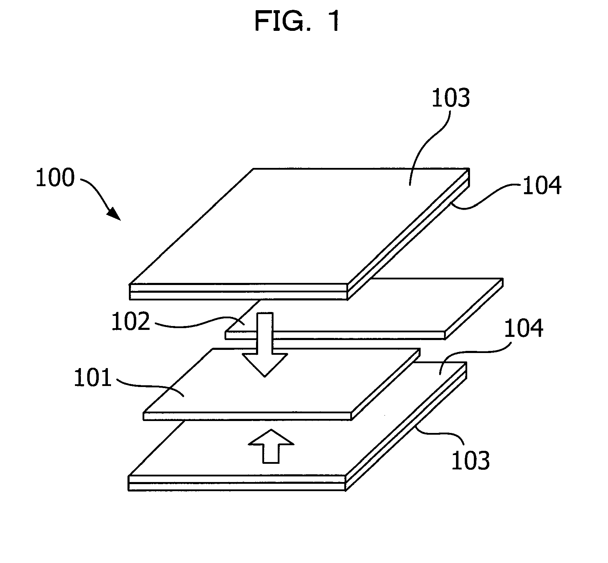

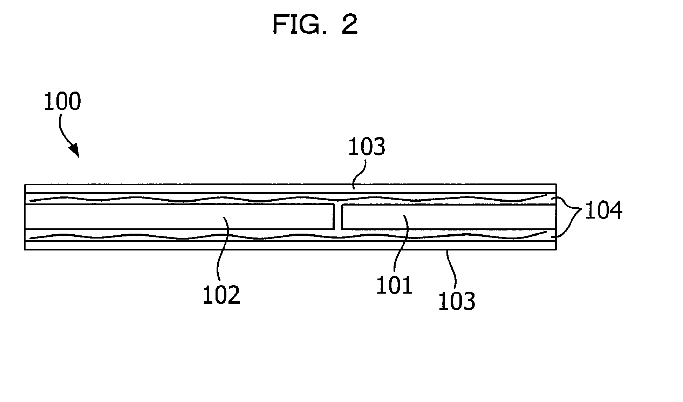

FIG. 1 is an exploded perspective view schematically illustrating a multilayered circuit board as an example of a first embodiment. FIG. 2 is a cross-sectional view illustrating the multilayered circuit board as an example of the first embodiment.

The printed circuit board 100 in the first embodiment includes a plurality of inner substrates 101 and 102 (here, two inner substrates as one example). Each of the inner substrates 101 and 102 is a laminate integrally constructed of conductor layers and insulation layers. Then, the inner substrates 101 and 102 have different numbers of conductor layers, respectively. However, if three or more inner substrates are laterally arranged, at least two of them may have different numbers of conductor layers.

Each of the inner substrates 101 and 102 extends in width and depth from FIG. 2. The inner substrates 101 and 102 are laterally aligned as illustrated in FIG. 2. In other words, the inner substrates 101 and 102 are laterally aligned in the direction along which each substrate extends. The inner substrates 101 and 102 may correspond to the examples of the first inner substrate and the second inner substrate of the invention, respectively.

The printed circuit board 100 according to the first embodiment also includes a metal layer 103 and an insulation layer 104. The metal layer 103 is a conductor pattern layer disposed on the insulation layer 104. A pair of the insulation layers 104 sandwiches the inner substrates 101 and 102 therebetween. A combination of the metal layer 103 and the insulation layer 104 corresponds to an example of a surface substrate in the multilayered circuit board. The insulation layer 104 corresponds to an example of the third insulation layer of the invention. Two or more metal layers may be alternately stacked with insulation layers. The metal layer 103 may be formed of copper foil, and the insulation layer 104 may be formed of thermosetting resin attached to the above copper foil. A pair of the insulation layers 104 may sandwich the inner substrates 101 and 102 thereinside and may be then formed into a laminate by, for example, heating under pressure in a thickness direction.

The insulation layer 104 is integrated with the inner substrates 101 and 102 and the metal layer 103. Since the insulation layer 104 according the first embodiment includes thermosetting resin, the resin material such as epoxy resin, Polyphenylene Ether (PPE) resin, olefin resin, or polyimide resin is initially softened by heating, and then cured. The insulation layer 104 is coupled to the inner substrates 101 and 102 through softening and curing. Alternatively, the insulation layer may contain a curing agent which cures at room temperature without heating. On the other hand, since the inner substrates 101 and 102 are beforehand prepared in cured conditions of insulation layers therein, the insulation layer 104 is not mixed with the insulation layers in the inner substrates 101 and 102 through the heating process under pressure.

FIG. 1 illustrates the insulation layers 104 in a flat sheet shape for the sake of simplicity. However, once the insulation layer 104 is softened by heating under pressure, the softened insulation layer 104 is introduced into and fills a gap between the laterally-aligned inner substrates 101 and 102 as shown in FIG. 2.

The printed circuit board 100 of the first embodiment is covered by the metal layer 103 and the insulation layer 104 such that the surface layer of the printed circuit substrate 100 is flat. Thus, a soldering process or the like can be performed on the surface layer of the printed circuit substrate 100 with a single process.

In each of FIG. 1 and FIG. 2, there is shown an exemplary arrangement in which two inner substrates 101 and 102 are laterally aligned in a simple manner. Nevertheless, two or more inner substrates may be arranged in various ways.

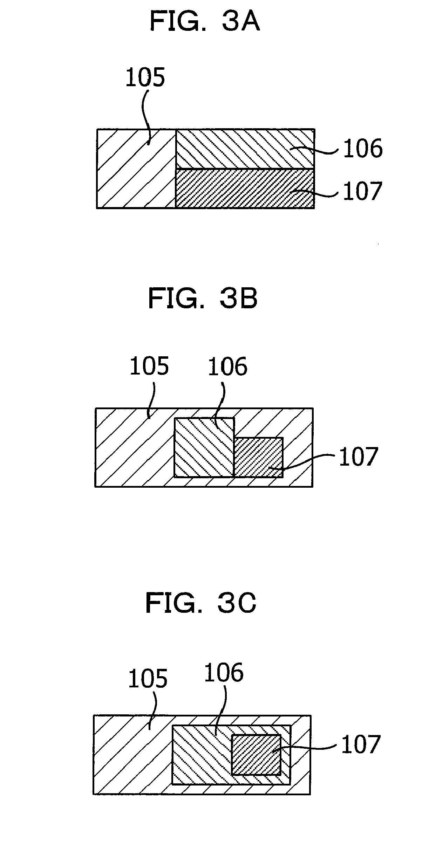

FIGs. 3A to 3C illustrate plan views regarding an exemplary arrangement of the inner substrate in the first embodiment.

In FIGs. 3A to 3C, any of the three different exemplary patterns of the arrangement satisfies the situation where substrates are aligned in the direction along which each of them extends.

In FIGs. 3A to 3C, the inner substrate 105 includes four conductor layers, the inner substrate 106 includes six conductor layers, and the inner substrate 107 includes eight conductor layers.

In FIG. 3A, the inner substrates 105, 106, and 107 are respectively arranged such that their outer edges are faced one another.

In FIG. 3B, the six-layered inner substrate 106 is laterally aligned with the eight-layered inner substrate 107. On the other hand, the four-layered inner substrate 105 laterally surrounds the six-layered inner substrate 106 and the eight-layered inner conductive substrate 107.

In FIG. 3C, the six-layered inner substrate 106 surrounds the eight-layered inner substrate 107. Furthermore, the four-layered inner substrate 105 further surrounds the six-layered inner substrate 106.

Thus, various arrangements may be applied to the inner substrates. Any of the arrangements can be designed based on the specifications of the respective electronic components to be mounted on a printed circuit board. In other words, a multilayered inner substrate is arranged on a portion on which an electronic component having narrow pitch between pins will be mounted. In contrast, an inner substrate with a small number of layers is arranged on a portion where the above narrow pitch components will be not mounted. Furthermore, as described above, the insulation layer disposed inside the inner substrates is not mixed with the insulation layer sandwiching the inner substrates because the curing process is separately executed. Thus, the materials of the insulation layer can be selected based on the desired specifications of each inner substrate. In this way, the arrangement and materials of the inner substrate can be designed without limitation, so that part of the printed circuit board 100 can be multilayered, or highly precise if required, while the total cost of the printed circuit board 100 can be reduced.

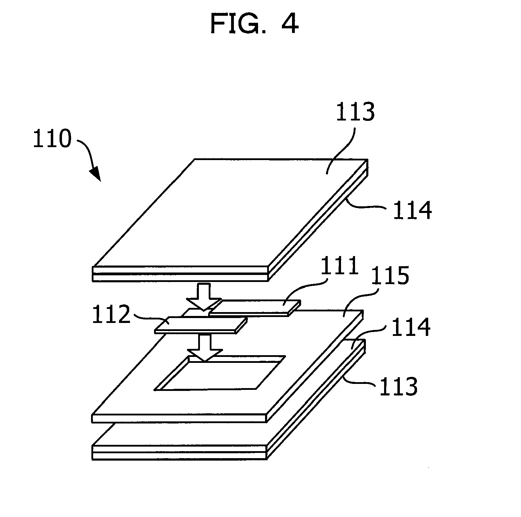

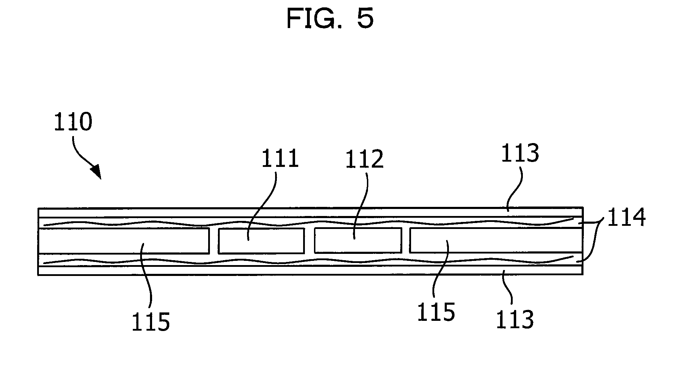

FIG. 4 schematically illustrates a printed circuit board according to a second embodiment. FIG. 5 is a cross-sectional view illustrating the printed circuit board according to the second embodiment.

The printed circuit board 110 in the second embodiment also includes a plurality of inner substrates 111 and 112 (here, two inner substrates as one example). Similarly to the inner substrates 101 and 102 in the first embodiment, each of the inner substrates 111 and 112 is a laminate which is integrally formed of conductor layers and insulation layers, while they have different numbers of the conductor layers.

Each of the inner substrates 111 and 112 in the second embodiment extends in width and depth from FIG. 5. The inner substrates 111 and 112 are laterally aligned as shown in FIG. 5. The inner substrates 111 and 112 may correspond to the first inner substrate and the second inner substrate of the invention.

The printed circuit board 110 in the second embodiment is provided with an insulation member 115 laterally surrounding the inner substrates 111 and 112. Here, the insulation member 115 is a plate containing a glass epoxy material.

Similarly to the first embodiment, the printed circuit board 110 in the second embodiment includes metal layers 113 and insulation layers 114. The metal layers 113 are conductor pattern formed on the insulation layers 114. A combination of the metal layer 113 and the insulation layer 114 corresponds to an example of a surface substrate that sandwiches the first inner substrate and the second inner substrate. Furthermore, the metal layer 113 may correspond to the conductor pattern of the invention.

The insulation layer 114 in the second embodiment is integrated integral structure with the inner substrates 111 and 112, the metal layer 113, and the insulation member 115. Similarly to the first embodiment, the insulation layer 114 includes a thermosetting resin which is initially softened by heating, and then cured. The insulation layer 114 is coupled to the inner substrates 111 and 112, and the insulation member 115 through softening and curing. The insulation layer 114 is not mixed with the insulation layers in the inner substrates 111 and 112 through the heating process under pressure.

FIG. 4 illustrates the insulation layers 114 in a flat sheet shape for the sake of simplicity. However, once the insulation layer 114 is softened by heating under pressure, the softened insulation layer 114 is introduced into and fills a gap between the laterally-aligned inner substrates 111 and 112, and the insulation member 115 as shown in FIG. 5. The insulation layer 114 may correspond to the third insulation layer of the invention.

The printed circuit board 110 of the second embodiment is covered by the metal layer 113 and the insulation layer 114 such that the surface layer of the printed circuit substrate 110 is flat. Thus, a soldering process or the like can be performed on the surface layer of the printed circuit substrate 110 with a single process.

Hereinafter, modified arrangements of the inner substrates with respect to the second embodiment will be described.

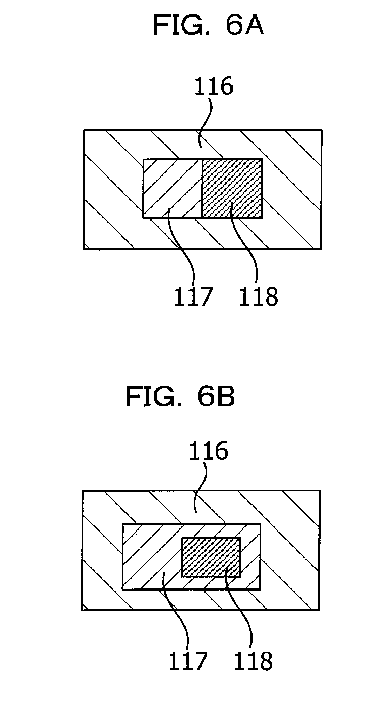

FIGs. 6A and 6B illustrate modified arrangements of the inner substrates.

In FIG. 6A, an inner substrate 117 having four conductor layers and an inner substrate 118 having eight conductor layers are surrounded by a frame-shaped insulation member 116.

The four-layered inner substrate 117 is laterally aligned with the eight-layered inner substrate 118. On the other hand, the frame-shaped insulation member 116 laterally surrounds the four-layered inner substrate 117 and the eight-layered inner substrate 118.

In FIG. 6B, the four-layered inner substrate 117 laterally surrounds the eight-layered inner substrate 118. The frame-shaped insulation member 116 laterally surrounds the four-layered inner substrate 117.

In addition, various arrangements of the inner substrates may be applied. Like the first embodiment, the materials of the insulation layer can be selected based on the desired specifications of each inner substrate. Therefore, in the second embodiment, the arrangement and materials of the inner substrate can be designed without limitation, so that part of the printed circuit board 110 can be multilayered or precise if required, while the total cost of the printed circuit board 110 can be reduced.

Hereinafter, a method for manufacturing a printed circuit board according to a third embodiment based on the printed circuit board in the above-described first embodiment will be described. The method for manufacturing the printed circuit board in the third embodiment can also similarly applied to the printed circuit board according to the above-described second embodiment. Here, the descriptions will be made with reference to the printed circuit board of the first embodiment for the sake of convenience.

The method for manufacturing the printed circuit board in the third embodiment roughly include the following processes: (i) a process for manufacturing an inner substrate, (ii) a process for arrangement of the inner substrate, (iii) a heating process under pressure, and (iv) a process for forming a conductor pattern or the like. Hereinafter, the above processes will be described in detail.

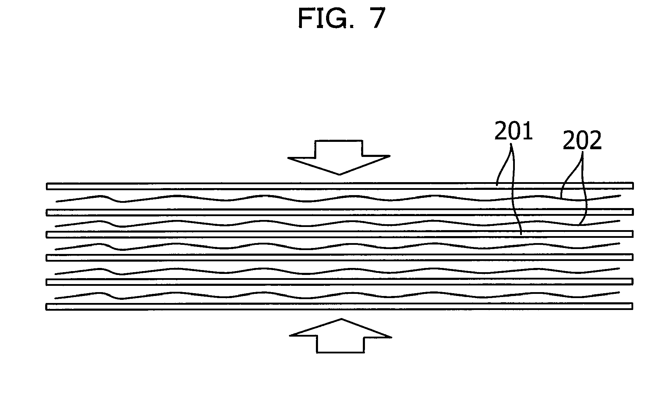

FIG. 7 illustrates a step of the process for manufacturing the inner substrate.

In the process for manufacturing the inner substrate, the conductor layers 201 are stacked alternately on insulation sheets 202 serving as insulation layers. A wiring pattern may be already formed in the conductor layer 201. A given number of conductor layers 201 is prepared for the inner substrate, and then laminated. In the third embodiment, the insulation sheet 202 is formed with a prepreg where a woven fiber (e.g., glass fibers, carbon fibers, aramid fibers, boron fibers and so on) is impregnated with thermosetting resin (e.g., epoxy resin, bismaleimide resin, polyimide resin and so on). In addition, the conductor layer 201 and the insulation sheet 202 have a surface area sufficient to cut into a plurality of inner substrates.

The alternately-stacked conductor layers 201 and insulation sheets 202 are heated under pressure with a hot press machine or the like in the arrow direction in Fig. 7, and then the insulation sheets 202 are cured. Thus, the conductor layers 201 and the insulation sheets 202 are integrally combined to complete a base substrate for cutting into a plurality of inner substrates. A specific heating process under pressure herein may be employed from any of techniques well known in the art, so that the details thereof will be omitted in the following description.

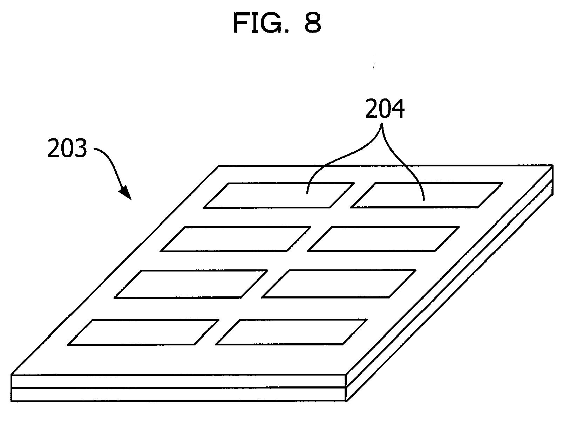

FIG. 8 illustrates another step of the process for manufacturing the inner substrate.

The formation of vias, recognition marks for alignment of inner substrates 204, through-holes to be used in the subsequent arrangement process, and so on are executed on the above-described base substrate 203. Then, a plurality of the inner substrates 204 is cut out from the base substrate 203.

In this way, two or more kinds of the inner substrate having different numbers of layers can be manufactured.

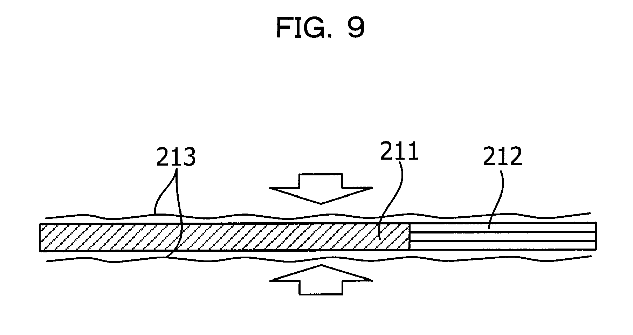

FIG. 9 is a schematic view illustrating a process for arranging the inner substrates.

In the arrangement process, the inner substrates 211 and 212 which are respectively produced by the foregoing process are laterally aligned in such a way as shown in FIGS. 1, 3, 4, and 6, and are sandwiched between two insulation sheets 213. The two insulation sheets 213 may correspond to the pair of the third insulation layers of the invention.

Specifically, the arrangement process may use a jig and be performed as follows.

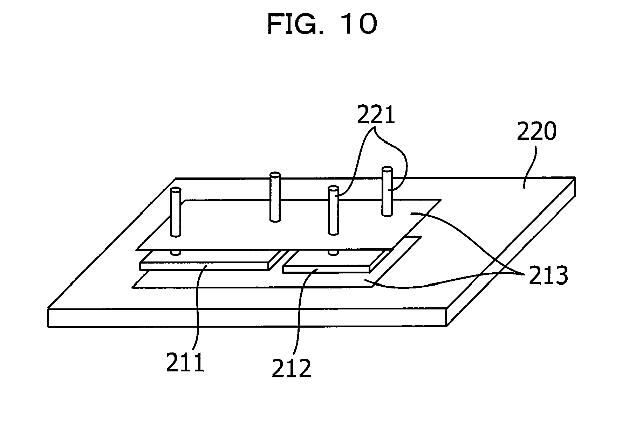

FIG. 10 illustrates a process for arranging the inner substrates with a jig.

A jig 220 is prepared in the arrangement process, and pins 221 are protruded from the flat surface of the jig 220. Then, the insulation sheet 213 is placed on the jig 220. The insulation sheet 213 has through-holes located at a position corresponding to the pins, respectively. The through-holes in the insulation sheet 213 are fitted into the pins 221, and the insulation sheet 213 is placed on the jig 220.

The inner substrates 211 and 212 also have through-holes at a given position. The inner substrates 211 and 212 are placed on the insulation sheet 213 while passing the pins 221 through the through-holes thereof. Therefore, the arrangement of the inner substrates 211 and 212 can be determined.

Furthermore, another insulation sheet 213 is placed on the inner substrates 211 and 212 while passing the pins 221 through the through holes.

In this way, in the present embodiment, the positions of the inner substrates 211 and 212 with reference to each other and the relative positions of the inner substrates 211 and 212 with respect to the insulation sheets 213 can be determined using the pins 221.

Subsequently, to keep their positional relationship, the inner substrates 211 and 212 and the insulation sheets 213 are temporarily joined by melting some portions of the insulation sheets 213 using a soldering iron or the like.

The process for arranging the inner substrates as described above, may correspond to aligning step of the invention.

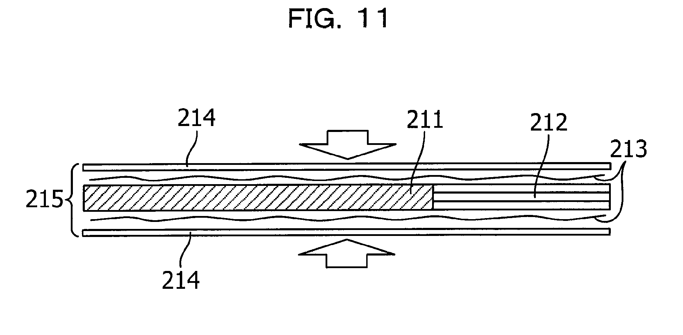

FIG. 11 is a schematic view illustrating a heating process under pressure.

In the heating process under pressure according to the third embodiment, the inner substrates 211 and 212 and the insulation sheets 213, which are temporarily joined as described above, are sandwiched by two sheets of copper foil 214. Hereinafter, the entire structure which is sandwiched by the sheets of copper foil 214 may be referred to as a laminated body 215. Furthermore, the laminated body 215 is heated while being pressurized in the arrow direction as shown in the FIG. 11. As a result, the insulation sheets 213 are softened through heating to allow the laminated body 215 to become an integrated structure.

In the third embodiment, the heating process under pressure is performed at once with respect to a plurality of the laminated bodies 215.

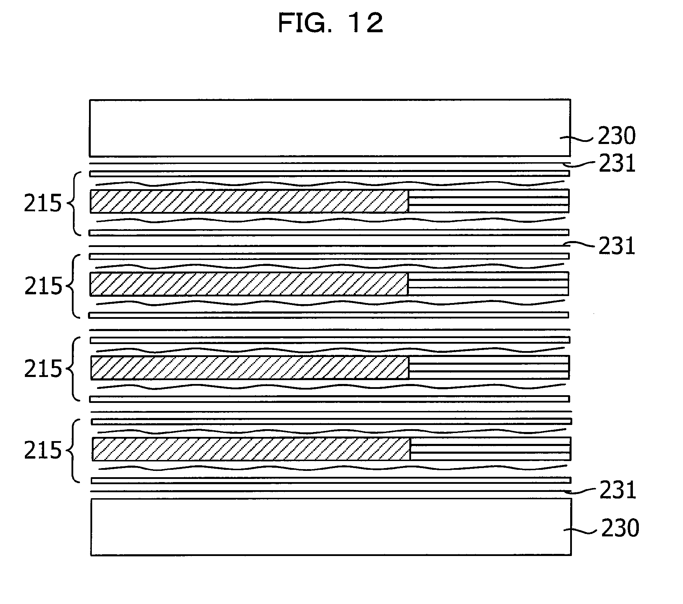

FIG. 12 is a view illustrating another example of heating process under pressure.

Here, as an example, there is shown a state that four laminated bodies 215 are stacked.

The laminated bodies 215 are stacked alternately with heat-resistant sheets 231, while the components are sandwiched between the iron bases 230 of a pressing machine. One of the heat-resistant sheets 231 is sandwiched between the iron base 230 and the laminated body 215 and another one of the heat-resistant sheets 231 is sandwiched between the laminated bodies 215. This heat-resistant sheet 231 is used for protecting the copper foil 214 of the laminated body 215.

After stacking the laminated bodies 215 as described above, the iron bases 230 with flat surfaces apply a pressure of several tons on the laminated bodies 215. Here, the laminated bodies 215 are also heated by a heater (not shown) and the applied heat softens the insulation sheets 213 in the respective laminated bodies 215. As a result, the insulation of the sheet 213 is integrally combined with the laminated body 215 and the resulting product servers as an insulation layer. Furthermore, the integrated laminated body 215 serves as a multilayered substrate with a flat surface.

The heating process under pressure shown in FIG. 12 may be one of conventional processes, which can be also used in the production of inner substrates.

Since copper foil entirely covers the surface of the multilayered substrate, an electronic component or the like cannot be mounted thereon yet. Therefore, as described below, the formation of conductor patterns or vias on the surface is performed to complete the circuit board in a state where electronic components or the like are mountable.

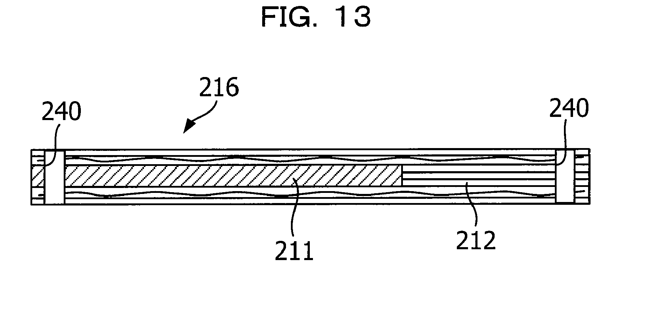

FIGs. 13 to 16 respectively illustrate the process for forming patterns or the like.

As shown in FIG. 13, reference holes 240 are formed in the multilayered substrate 216. The reference holes 240 are formed at a position corresponding to the above-described recognition marks on the inner substrates 211 and 212. The position of the recognition marks may be read by using X-rays.

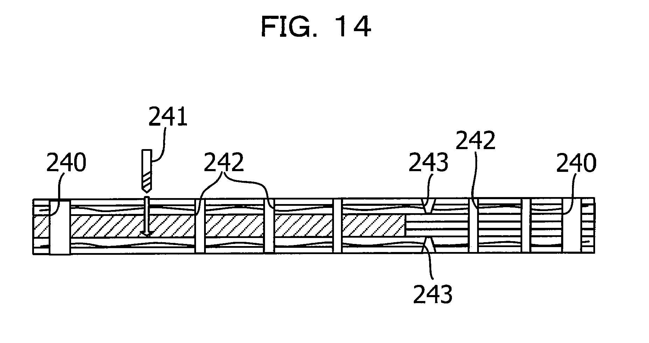

In FIG. 14, a through-hole 242 or a non-through-hole 243 is formed by a drill at each position positioned on the basis of the reference hole 240.

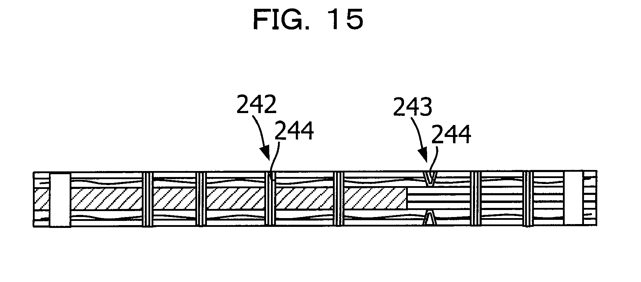

In FIG. 15, a plating film 244 is formed on the inner wall of the through hole 242 and the non-through hole 243 by a plating treatment.

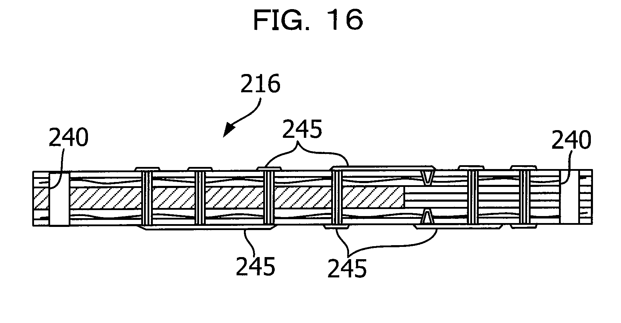

In FIG. 16, a conductor pattern (trace) 245 is formed on the surface of the multilayered substrate 216 by photoengraving or printing technology at the position formed on the basis of the reference hole 240 opened at the reference position.

Through the pattern-formation process, the multilayered substrate 216 is made into a printed circuit board on which electronic components are mountable.

Although the pattern-formation process is described to be executed after the heating process under pressure in the third embodiment, the pattern-formation process may be executed before the heating process under pressure, or before aligning the inner substrates.

Hereinafter, the details of a substrate structure applicable to the printed circuit board in the above-described embodiments will be described. The term "substrate structure" herein can include a layered structure and a wiring structure.

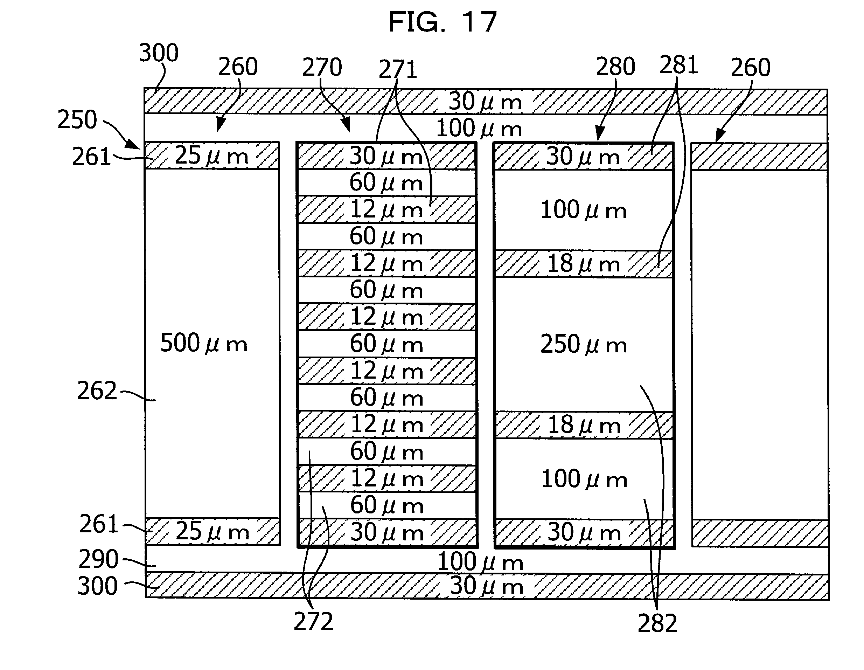

FIG. 17 is a view illustrating an example of a layered structure applicable to each embodiment.

The printed circuit board 250 described herein includes three different inner substrates having two, eight, and four layers, respectively.

The two-layered inner substrate 260 includes conductor layers 261 each having thickness of 25 µm and an insulation layer 262 having thickness of 500 µm. The insulation layer 262 is sandwiched between the conductor layers 261.

The four-layered inner substrate 280 includes conductor layers each having thickness of 18 µm or 30 µm and insulation layers 282 each having thickness of 100 µm or 250 µm. Each insulation layer 282 is sandwiched between the conductor layers 281.

The eight-layered inner substrate 270 includes conductor layers each having thickness of 12 µm or 30 µm and an insulation layers 272 having thickness of 60 µm. The insulation layers 272 are sandwiched between the conductor layers 271.

The inner substrates 260, 270, and 280 are disposed between the surface layer patterns 300 each having a thickness of 30 µm. An insulation layer 290 integrally combines the inner substrates 260, 270, and 280 with the surface patterns 300. The layer thickness of the pair of the insulation layers 290 which is located above or below each of the inner layer structure 260, 270, and 280 is, in this example, 100 µm. Thus, the insulation layer 290 has a sufficient thickness to absorb a difference in thickness among the inner substrates 260, 270, and 280. These layer thicknesses can be suitably controlled in various embodiments.

Among the above-described inner substrates 260, 270, and 280, the eight-layered inner substrate 270 has the finest structure. Thus, the material of the insulation layer 272 therein is high-insulation performance resin to reliably insulate between the narrow pitch traces.

On the other hand, since the two-layered inner substrate 260 has the thickest insulation layer 262, the lower insulation performance can be permissible as compared to the eight-layered inner substrate 270. Therefore, a low-cost resin material can be employed to the two-layered inner substrate 260.

The four-layered inner substrate 280 among the inner substrates 260, 270, and 280 can be suitable for high-speed transmission. Therefore, the insulation layer 282 of the four-layered inner substrate 280 may employ ceramics to obtain a high-speed transmission capability. A insulation layer including ceramics may also be employed to a region where a power circuit requiring a high heat-resistant performance is mounted.

As a modified example, the first insulation layer and the second insulation layer may include different materials. A suitable material selection may lead to a high-performance circuit board at low cost.

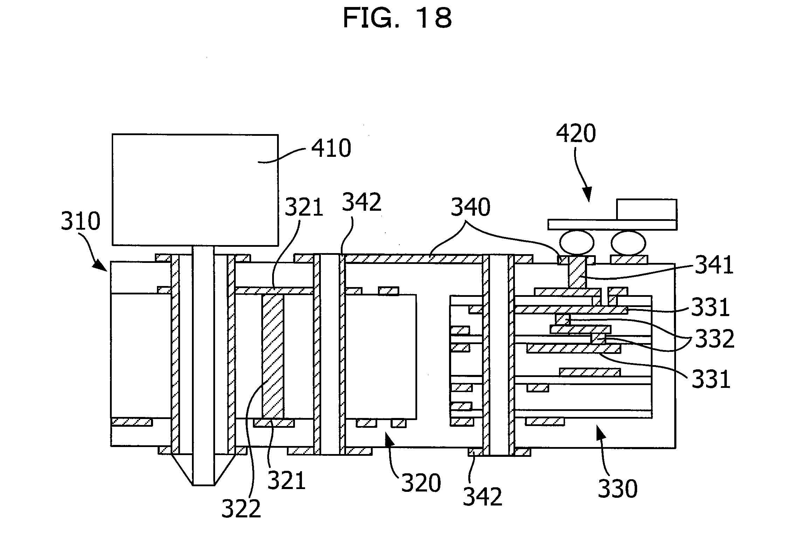

FIG. 18 is a view illustrating an example of a wiring structure applicable to each embodiment.

A printed circuit board 310 in FIG. 18 includes a two-layered inner substrate 320 and an eight-layered inner substrate 330.

The two-layered inner substrate 320 is provided with an inner via 322 connecting inner layer patterns 321 one another.

The inner via 322 is formed with a buried via inside the printed circuit board 310. In other words, the inner via 322 does not reach the surface of the printed circuit board 310. In addition, the eight-layered inner substrate 330 is also provided with an inner via 332 connecting inner layer patterns 331 one another. The inner via 322 is also formed with a buried via inside both the eight-layered inner substrate 330 and the printed circuit board 310, which do not reach the surface of the printed circuit board 310.

The inner vias 322 and 332 are formed during the manufacture of the inner substrates.

The printed circuit substrate 310 is provided with an inner via 341 that connects the surface layer pattern 340 with the inner layer pattern 331 of the inner substrate 330. The inner via 341 reaches the surface of the printed circuit board 310. In addition, the printed circuit board 310 is also provided with a through-hole via 342 that connects the surface layer patterns 340 on the front and back sides of the printed circuit board 310 with the inner layer patterns 321 of the inner substrate 320. The through-hole via 342 also reaches the surface of the printed circuit board 310. The through-hole via 342 and the inner via 341 both of which reach the surface of the printed circuit board 310 are formed during the above-described pattern-formation process such as through hole and/or the non-through hole.

FIG. 18 also illustrates a Dual-In-line Plug (DIP) connector 410 and a Ball Grid Array (BGA) component 420 which are mounted on the printed circuit board. The BGA component 420 has more terminals with narrow pitches than the DIP connector 410. Thus, the BGA 420 is mounted on the region where the multilayered (e.g., eight-layered) inner substrate 330 is disposed. On the other hand, the DIP connector 410 may be mounted on the region where the two-layered inner substrate 320 is disposed.

In particular, since the multilayered inner substrate 330 is provided with an inner via 332 that does not reach the surface of the printed wiring substrate 310, the inner layer patterns 331 are connected one another without interfering with a mounting region on the surface of the printed circuit board 310.

The inner substrates 320 and 330 in FIG. 18 may correspond to the first inner substrate and the second inner substrate of the invention.

At least one of the first inner substrate and the second inner substrate of the invention preferably has the inner via which does not reach the surface of the printed circuit board.

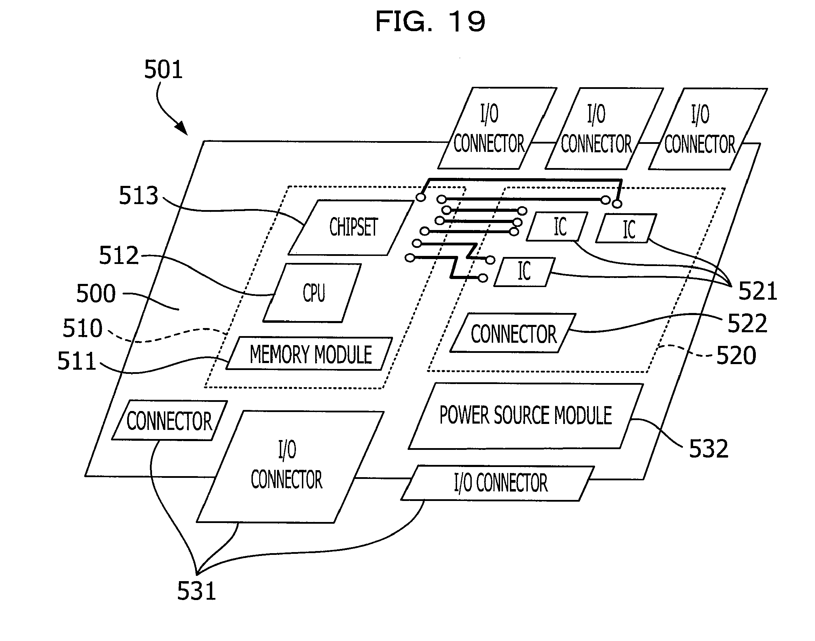

Hereinafter, an electronic apparatus in which a printed circuit board according to the above-described embodiments is installed will be described with reference to FIG. 19.

FIG. 19 is a personal computer as an example of the electronic apparatus according to a fourth embodiment. FIG. 19 illustrates an example regarding the internal configuration of the personal computer 501, but the enclosure thereof is omitted for the sake of convenience.

The personal computer 501 includes various kinds of electronic components mounted on a printed circuit board 500. For example, a memory module 511, a central processing unit (CPU) 512, a chip set 513, integrated circuits (ICs) 521, connectors 522 and 531, and a power source module 532 are mounted on the printed circuit board 500.

In addition, the printed circuit board 500 can include two inner substrates 510 and 520 inside thereof. In other words, the printed circuit board 500 illustrated herein has a structure similar to that of the printed wiring substrate 110 according to the second embodiment as shown in FIG. 4.

The printed circuit board 500 in FIG. 19 has a dimension of 160 mm in length, 300 mm in width, and 0.81 mm in thickness. In addition, the wiring pattern on the surface layer of the printed circuit board 500 has a dimension of a minimum width of 100 µm and a minimum gap of 100 µm.

In FIG. 19, the inner substrate 510 is formed into a multilayered and fine substrate. The inner substrate 510 has a dimension of, for example, 60 mm in length, 60 mm in width, and 0.55 mm in thickness. The inner substrate 510 is an eight-layered substrate. In addition, the wiring pattern of the inner substrate 510 has a dimension of a minimum width of 50 µm and a minimum gap of 50 µm. Among the various kinds of electronic components as mentioned above, electronic components each having a comparatively large number of wirings, such as the memory module 511, the CPU 512, and the chip set 513, are mounted on a region where the multilayered and fine inner substrate 510 is disposed.

In FIG. 19, the inner substrate 520 has a dimension of, for example, 100 mm in length, 100 mm in width, and 0.55 mm in thickness. The inner substrate 520 is a four-layered substrate. In addition, the wiring pattern of the inner layered substrate 520 has a dimension of a minimum width of 100 µm and a minimum gap of 100 µm. Among the various kinds of electronic components as mentioned above, the IC 521 and the connector 522, each of which has a certain number of wirings but less than that of the CPU 512 or the like, can be mounted on a region where the inner substrate 520 is disposed.

On the other hand, the I/O connectors 531 and the power source module 532 may be sufficiently dealt with the wiring patterns on the surface layer of the printed circuit board 500, and be mounted on a region apart from the inner substrates 510 and 520.

Therefore, the personal computer 501 in FIG. 19 employs the printed circuit board 500 which is partially multilayered depending on the specifications of electronic components to be mounted, so that it can be provided with advanced features while avoiding an increase in cost.

Although the personal computer is described as one example of the electronic apparatus in the fourth embodiment. Alternatively, a mobile phone, switchboard, a server, or the like may be applied to an example of the electronic apparatus with the fourth embodiment.

All examples and conditional language recited herein are intended for pedagogical objects to aid the reader in understanding the invention and the concepts contributed by the inventors to further the art, and are to be construed as being without limitation to such specifically recited examples and conditions, nor does the organization of such examples in the specification relate to a showing of the superiority and inferiority of the invention. Although the embodiments of the invention have been described in detail, it will be understood by those of ordinary skill in the relevant art that various changes, substitutions, and alterations could be made hereto without departing from the spirit and scope of the invention as set forth in the claims.

## Claims

1. A method for manufacturing a multilayered circuit board, said method comprising:
laterally aligning a first inner substrate in which first insulation layers and first conductor layers are alternately laminated and a second inner substrate in which second insulation layers and second conductor layers are alternately laminated, wherein the second inner substrate has a lager number of layers than the first inner substrate;
placing the laterally aligned first inner substrate and second inner substrate between a pair of third insulation layers in a thickness direction;
heating under pressure the pair of the third insulation layer in the thickness direction; and
forming a conductor pattern on surfaces of the pair of the third insulation layers.

2. The method for manufacturing a multilayered circuit board according to claim 1, wherein the first insulation layer includes a first thermosetting resin, and
the first insulation layer is integrated with the first conductor layer by curing the first thermosetting resin.

3. The method for manufacturing a multilayered circuit board according to claim 1, wherein the second insulation layer includes a second thermosetting resin, and
the second insulation layer is integrated with the second conductor layer by curing the second thermosetting resin.

4. The method for manufacturing a multilayered circuit board according to claim 1, further comprising forming an inner via in at least one of the first inner substrate and the second inner substrate.

5. The method for manufacturing a multilayered circuit board according to claim 1, wherein the third insulation layer includes a third thermosetting resin.

6. The method for manufacturing a multilayered circuit board according to claim 5, wherein the third insulation layer is formed with a prepreg in which woven fibers are impregnated with the third thermosetting resin

7. A multilayered circuit board, comprising:
a first inner substrate in which first insulation layers and first conductor layers are alternately laminated;
a second inner substrate laterally aligned with the first inner substrate, wherein second insulation layers and second conductor layers are alternately laminated, and wherein the second inner substrate has a larger number of layers than the first inner substrate; and
a pair of surface substrates each having a third insulation layer and a conductor pattern formed on the surface of the third insulation layer,
wherein the first inner substrate and the second inner substrate are disposed between the pair of the surface substrates.

8. The multilayered circuit board according to claim 7, wherein an inner via is formed in at least one of the first inner substrate and the second inner substrate.

9. The multilayered circuit board according to claim 7, wherein the first insulation layer and the second insulation layer include different kinds of thermosetting resin.

10. The multilayered circuit board according to claim 7, wherein the third insulation layer includes a third thermosetting resin.

11. The method for manufacturing a multilayered circuit board according to claim 10, wherein the third insulation layer is formed with a prepreg in which woven fibers are impregnated with the third thermosetting resin

12. An electronic apparatus comprising:
an enclosure;
a multilayered circuit board installed in the enclosure; and
an electronic component mounted on the multilayered circuit board, wherein the multilayered circuit board includes:
a first inner substrate in which first insulation layers and first conductor layers are alternately laminated;
a second inner substrate laterally aligned with the first inner substrate, wherein second insulation layers and second conductor layers are alternately laminated, and wherein the second inner substrate has a larger number of layers than the first inner substrate; and
a pair of surface substrates having a third insulation layer and a conductor pattern formed on the surface of the third insulation layer,
wherein the first inner substrate and the second inner substrate are disposed between the pair of the surface substrates.
